# FASCICULE DE BREVET EUROPEEN

(11) **EP 1 629 420 B1**
(45) Date de publication et mention de la délivrance du brevet: **15.08.2007**
(21) Numéro de dépôt: 04767177.1
(22) Date de dépôt: 26.05.2004
(51) Int. Cl.: G06K 19/077

(54) **PROCEDE DE FABRICATION D'UN TICKET A PUCE SANS CONTACT**
VERFAHREN ZUR HERSTELLUNG EINES KONTAKTLOSEN TICKETS
METHOD FOR PRODUCING A CONTACTLESS TICKET

(30) Priorité: 26.05.2003 FR 0306309
(43) Date de publication de la demande: 01.03.2006
(73) Titulaire: ASK S.A., 06560 Valbonne (FR)
(72) Inventeur: HALOPE, Christophe, F-06400 Cannes (FR)
(86) Numéro de dépôt international: PCT/FR2004/001299
(87) Numéro de publication internationale: WO 2004/107260

(56) Documents cités:
- WO-A-99/17252
- WO-A-03/025850
- US-A- 6 147 662

## Description

### Domaine technique

La présente invention concerne un procédé de fabrication de ticket muni d'une puce et d'une antenne sérigraphiée et concerne en particulier un procédé de fabrication d'un ticket sans contact et le ticket obtenu à partir de ce procédé.

### Etat de la technique

Les tickets électroniques de type sans contact à identification radio-fréquence (RFID) appelés plus communément tickets à lecture sans contact ou étiquettes à lecture sans contact sont munis d'une antenne et d'un circuit intégré sous forme d'une puce électronique connectée à l'antenne, l'ensemble étant réalisé sur un support souple. Les tickets électroniques de type sans contact peuvent échanger et transmettre des données à distance par couplage inductif, par l'intermédiaire de leur antenne grâce à un lecteur muni également d'une antenne. Le support souple est en papier, en carton ou en plastique. Dans une forme de réalisation économique des tickets, l'antenne est imprimée par sérigraphie. L'impression sérigraphique consiste à imprimer les spires de l'antenne sur un substrat électriquement isolant, de préférence en papier, à l'aide d'une encre conductrice par exemple constituée majoritairement de poudre d'argent. Pour la fabrication des tickets munis d'antenne sérigraphiée il est possible d'utiliser un mode de fabrication en continu. WO-A- 99/17252 divulgue un tel procédé de fabrication avec les caractéristiques du préambule de la revendication 1.

Ainsi, la demanderesse a personnellement développé un procédé de fabrication où l'impression sérigraphique de l'antenne est réalisée sur une face d'une bande de papier sans fin dont la largeur permet la fabrication d'un ou plusieurs tickets. Sur la face de la bande de papier opposée à la face portant l'antenne, des repères constitués de marques imprimées ou de trous sont effectués afin de repérer la zone correspondant à chaque ticket dans la direction d'avance de la bande de papier et éventuellement les rangées de tickets dans la largeur de la bande de papier. Ces repères sont essentiels au procédé de fabrication des tickets en continu. En effet, à chaque étape de fabrication du ticket, la bande de papier étant déroulée entièrement puis ré-enroulée afin de pouvoir être manipulée et stockée entre deux étapes de fabrication, le repérage de l'emplacement exact de chaque ticket est effectué. Ainsi, le procédé de fabrication en continu des tickets sans contact se décompose en un certain nombre d'étapes effectuant l'impression du visuel du client, l'impression de l'antenne, la pose de la puce et la lamination finale qui consiste à déposer la couche préalablement imprimée du visuel du client sur la face du ticket portant l'antenne et la puce. L'impression de l'antenne nécessite plusieurs passages. En effet, la réalisation de l'antenne consiste à imprimer les spires de l'antenne formant une spirale conductrice, réaliser une bande de diélectrique perpendiculairement aux spires et imprimer un pont d'encre conductrice sur la bande de diélectrique permettant de relier une des extrémités de l'antenne à la borne de connexion qui servira à assurer la liaison électrique avec la puce.

L'étape qui consiste à positionner la puce électronique sur les tickets à l'emplacement prévu pour être connectée à l'antenne est une étape primordiale dans la fabrication du ticket et nécessite beaucoup de précision. Grâce aux repères préalablement effectués sur la face opposée du support de l'antenne et à une détection optique des repères, la puce est placée exactement à l'endroit voulu. Cependant, il peut s'avérer que le positionnement soit mal effectué et dans ce cas, la connexion de la puce et de l'antenne est défectueuse. Les repères servent également à la découpe de la bande en ticket unitaire.

L'inconvénient majeur de ce type de procédé de fabrication en continu réside dans le fait que l'encre argent constitutive de l'antenne se reporte sur l'envers de la bande de papier par frottement lors des enroulements et déroulements successifs nécessaires pour terminer la fabrication du ticket. Lorsque l'envers de la bande de papier est préalablement imprimé du visuel du client, il s'ensuit une trace apparente à l'oeil nu sur le visuel du client, ce qui nuit à l'esthétique finale du ticket. De plus, le report d'encre pourrait également recouvrir les repères sur l'envers de la bande de papier dans le cas où ceux-ci se trouvent dans le champ de l'antenne et perturber ainsi le repérage optique effectué lors des étapes de fabrication et de distribution du ticket. Ainsi, les étapes qui consistent à positionner la puce et à découper les tickets pourraient échouer et entraîner une baisse du rendement de fabrication des tickets.

### Exposé de l'invention

Le but de l'invention est donc de pallier ces inconvénients en fournissant un procédé de fabrication de tickets sans contact en continu sur une bande sans fin permettant de réaliser l'antenne par sérigraphie d'encre conductrice sans que l'encre se reporte par frottement sur l'envers de la bande et sans ajouter d'étape supplémentaire à la fabrication du ticket.

L'objet de l'invention est donc un procédé de fabrication de tickets ou cartes sans contact comprenant une puce connectée à une antenne sur un support en papier et les étapes du procédé consistant à imprimer en série à l'aide d'une encre sérigraphique les antennes sur la bande support, à fixer une puce sur chaque ticket par connexion des plots de la puce aux plots de l'antenne et à recouvrir la bande de papier comportant les antennes sérigraphiées et les puces correspondantes par une bande de papier adhésivée, chacune des étapes étant suivie de l'enroulement de la bande de support en papier avant de passer à l'étape suivante. Cette l'étape consistant à imprimer les antennes comprend un revêtement de chacune des antennes par une couche de protection imprimée et susceptible d'empêcher l'encre sérigraphique d'être reportée sur le verso de la bande de support en papier lors des enroulements successifs de celle-ci après chaque étape.

### Brève description des dessins

Les buts, objets et caractéristiques de l'invention apparaîtront plus clairement à la lecture de la description qui suit faite en référence aux dessins dans lesquels :
La figure 1 représente l'antenne d'un ticket sans contact qui a été réalisée par impression d'une encre sérigraphique,
La figure 2 représente l'antenne recouverte d'une couche diélectrique de protection réalisée selon les principes de l'invention, et
La figure 3 représente le ticket avec l'antenne sérigraphiée recouverte de la couche diélectrique après l'étape de fixation de la puce par connexion aux extrémités de l'antenne.

### Description détaillée de l'invention

Dans le procédé de fabrication d'un ticket sans contact selon l'invention, chaque étape consiste à effectuer une opération identique sur une bande sans fin dont la largeur permet la fabrication d'un ou plusieurs tickets de front (par exemple 6 tickets). Lorsque toutes les étapes ont été effectuées, on procède au découpage de façon à obtenir des tickets individuels.

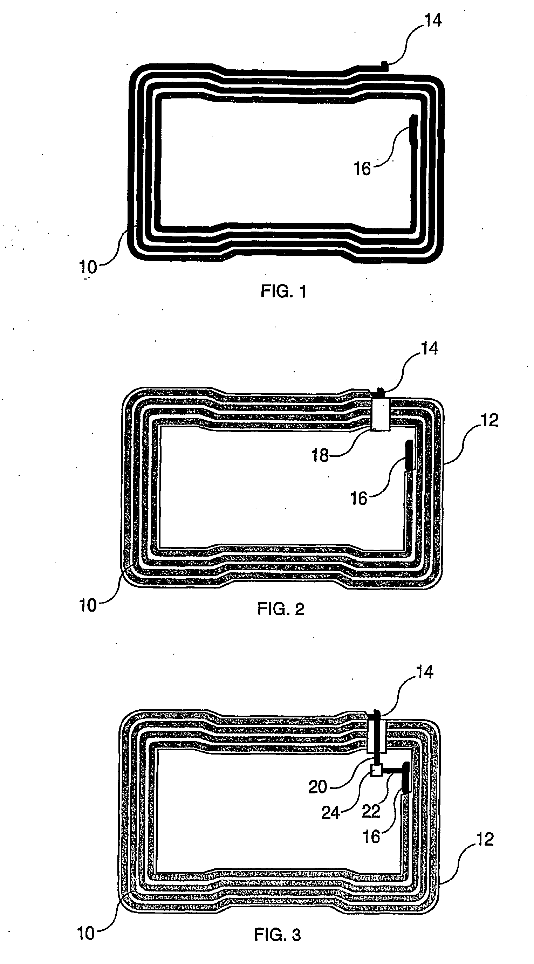

Avant la première étape du procédé de fabrication, c'est une bobine d'une certaine longueur d'une bande de papier nu qui est installée dans la machine de fabrication. La bobine est déroulée de façon à effectuer la première étape qui consiste à réaliser l'antenne 10 par impression sérigraphique à l'aide d'une encre à base d'argent illustrée sur la figure 1.

L'étape suivante consiste à déposer, toujours par sérigraphie, une couche de protection 12 recouvrant l'antenne 10. Dans le mode de réalisation préféré illustré sur la figure 2, la couche de protection est réalisée sur toute la surface de l'antenne 10 de façon à recouvrir cette dernière. Mais on peut concevoir un mode de réalisation dans lequel la couche de protection ne recouvre que les spires de l'antenne, en d'autres termes son empreinte exacte. Toujours selon le mode de réalisation préféré, la couche de protection est une couche diélectrique.

Cette couche de protection a pour but d'empêcher le report par frottement de l'encre constituant l'antenne 10 qui vient d'être fixée sur la bande de papier lors des enroulements subséquents de la bande qui suivent l'étape d'impression sérigraphique.

Comme il a été mentionné précédemment, un tel report nuit à l'esthétique finale du ticket et risque de recouvrir les repères effectués sur l'envers de la bande et donc de perturber leur repérage optique.

Cette couche de protection qui est une couche diélectrique dans la suite du texte, comporte deux particularités. Tout d'abord, elle ne doit pas recouvrir les extrémités 14, 16 de l'antenne qui vont servir de connexions avec la puce. Ensuite, cette impression sérigraphique du diélectrique réalisée en une seule étape n'est pas la même pour un rectangle 18 sur lequel sera effectuée, à l'étape suivante, l'impression d'une bande conductrice destinée à relier l'extrémité 14 de l'antenne au plot de connexion de la puce.

L'impression de la couche 12 est réalisée pendant la même étape que l'impression de l'antenne par sérigraphie, ceci pour éviter qu'il y ait report de l'encre du verso du ticket.

Comme déjà mentionné, l'impression de la couche diélectrique est différente pour le rectangle 18 recouvrant les spires de l'antenne. En effet, la couche de diélectrique sur l'ensemble de l'antenne a seulement pour but d'éviter le report de l'encre sur le verso des tickets alors que le diélectrique du rectangle 18 a pour but d'isoler les spires de l'antenne de la bande conductrice 20 illustrée sur la figure 3. Ce rectangle doit donc être parfaitement isolant électriquement ce qui n'est pas forcément nécessaire pour l'ensemble de la couche diélectrique réalisée dans un but de protection. Une technique préférée consiste a utiliser un écran de sérigraphie dont l'essentiel est en tramé sauf la partie correspondant au rectangle 18 qui est un aplat. Ceci permet d'avoir un revêtement de 100% de diélectrique pour le rectangle 18 et de seulement 30% de diélectrique pour le reste de la couche diélectrique 12.

Après un nouvel enroulement de la bande, le procédé passe à l'étape suivante qui consiste à imprimer par sérigraphie les connexions de l'antenne à la puce, c'est à dire la bande conductrice 20 à partir de l'extrémité 14 de l'antenne 10 et une bande conductrice 22 à partir de l'extrémité 16 de l'antenne. Comme illustré sur la figure 3, ceci permet la connexion de la puce 24 au cours de l'étape suivante, par fixation des plots de connexion de la puce sur les extrémités des bandes conductrice 20 et 22.

A noter que l'impression par sérigraphie des bandes conductrices 20 et 22 après l'impression de la couche diélectrique de protection 12 ne pose pas le même problème de report d'encre que l'antenne. En effet, les spires longitudinales de l'antenne sont situées les unes au-dessus des autres dans la bobine après enroulement, ce qui crée donc une surépaisseur et par conséquent un risque accru de report d'encre par frottement sur le verso des tickets du fait de la pression occasionnée par cette surépaisseur. Par contre, les deux bandes conductrices 20 et 22, de dimensions réduites, ne se retrouvent pas au même endroit dans la bobine résultant de l'enroulement de la bande. Il n'y a donc pas surépaisseur et par conséquent un risque faible de report d'encre par frottement sur le verso des tickets.

Bien que le procédé selon l'invention a été décrit en référence à la fabrication de tickets en papier, il pourrait s'appliquer également à la fabrication de cartes sans contact ou tous autres objets de type sans contact (étiquettes, tags) dans lesquels l'antenne est réalisée à l'aide d'une encre sérigraphique.

## Revendications

1. Procédé de fabrication en plusieurs étapes de tickets ou cartes sans contact comprenant une puce (24) connectée à une antenne (10) sur un support en papier, les étapes dudit procédé consistant à imprimer en série à l'aide d'une encre sérigraphique les antennes sur ladite bande support en papier, à fixer une puce sur chaque ticket par connexion des plots de connexion de la puce aux plots de connexion de l'antenne (14, 16) et à recouvrir ladite bande de papier comportant les antennes sérigraphiées et les puces correspondantes par une bande de papier adhésivée, chacune des étapes étant suivie de l'enroulement de ladite bande de support en papier avant de passer à l'étape suivante;
ledit procédé étant **caractérisé en ce que** l'étape consistant à imprimer les antennes comprend un revêtement de chacunes des antennes sérigraphiées par une couche de protection (12) déposée par impression, notamment par impression sérigraphique, ladite couche de protection étant susceptible d'empêcher l'encre sérigraphique d'être reportée sur le verso de ladite bande de support en papier lors des enroulements successifs de celle-ci après chaque étape.

2. Procédé selon la revendication 1, dans lequel ladite couche de protection est une couche diélectrique.

3. Procédé selon la revendication 2, dans lequel ladite couche diélectrique est imprimée à l'aide d'une encre sérigraphique pendant la même étape que l'étape d'impression sérigraphique de l'antenne sur le support en papier.

4. Procédé selon la revendication 3, dans lequel la partie (18) de ladite couche diélectrique (12) destinée à recevoir une bande conductrice reliant l'extrémité de l'antenne sérigraphiée (10) à un plot de connexion de la puce (24) est plus importante que le reste de ladite couche diélectrique.

5. Procédé selon la revendication 4, dans lequel ladite partie (18) de la couche diélectrique (12) destinée à recevoir ladite bande conductrice comprend 100% de diélectrique alors que le reste de ladite couche diélectrique comprend 30% de diélectrique.

6. Procédé selon la revendication 5, dans lequel l'écran de sérigraphie servant à réaliser ladite couche diélectrique (12) comporte un aplat correspondant à ladite partie (18) destinée à recevoir ladite bande conductrice alors que le reste de ladite couche diélectrique est en tramé.

## Claims

1. A method for the multi-step manufacture of contactless tickets or cards including a chip (24) connected to an antenna (10) on a paper support, said method consisting in printing in series, using screen printing ink, the antennas on said paper support strip, in fixing a chip on each ticket by connecting the bonding pads of the chip to the bonding pads of the antenna (14, 16) and in covering said paper strip comprising the screen-printed antennas and the corresponding chips with an adhesive paper strip, each of the steps being followed by the winding of said paper support strip before moving onto the next step;
said method being **characterised in that** it includes a step consisting in covering each of said screen-printed antennas with a protective layer (12), applied by printing, and particularly screen printing, said protective layer being provided for preventing the screen printing ink from being transferred onto the back of the paper support strip during the successive windings thereof after each step.

2. The method according to Claim 1, wherein said protective layer is a dielectric layer.

3. The method according to Claim 2, wherein said dielectric layer is printed using a screen printing ink during the step consisting in screen printing the antenna onto the paper support.

4. The method according to Claim 3, wherein the part (18) of said dielectric layer (12) for receiving a conductive strip connecting the end of the screen-printed antenna (10) to a bonding pad of the chip (24) is greater than the rest of said dielectric layer.

5. The method according to Claim 4, wherein said part (18) of the dielectric layer (12) for receiving said conductive strip is made up of 100% dielectric, whereas the rest of said dielectric layer is made up of 30% dielectric.

6. The method according to Claim 5, wherein said print screen which is used to produce said dielectric layer (12) comprises a full-tone screen corresponding to said part (18) for receiving said conductive strip, whereas the rest of said dielectric layer is half-tone printed.

## Patentansprüche

1. Verfahren zum Herstellen in mehreren Schritten von kontaktlosen Tickets oder Karten, die einen Chip (24) enthalten, der mit einer Antenne (10) auf einem Papierträger verbunden ist, wobei die Schritte des Verfahrens darin bestehen, die Antennen mit Hilfe einer Siebdrucktinte reihenweise auf das Trägerband aus Papier zu drucken, einen Chip auf jedem Ticket durch Verbinden der Anschlussflächen des Chips mit den Anschlussflächen der Antenne (14, 16) zu befestigen und das Papierband, das die Siebdruckantennen und die entsprechenden Chips enthält, mit einem Papierklebeband abzudecken, wobei jedem der Schritte das Aufrollen des Trägerbandes aus Papier folgt, bevor zum nächsten Schritt übergegangen wird;
wobei das Verfahren **dadurch gekennzeichnet ist, dass** der Schritt, der darin besteht, die Antennen zu drucken, das Beschichten jeder der Siebdruckantennen mit einer Schutzschicht (12), die durch Druck, insbesondere durch Siebdruck aufgebracht wird, enthält, wobei die Schutzschicht verhindern kann, dass die Siebdrucktinte auf die Rückseite des Trägerbandes aus Papier übertragen wird, wenn dieses nach jedem Schritt nacheinander aufgerollt wird.

2. Verfahren nach Anspruch 1, wobei die Schutzschicht eine dielektrische Schicht ist.

3. Verfahren nach Anspruch 2, wobei die dielektrische Schicht mit Hilfe einer Siebdrucktinte im selben Schritt wie dem Schritt, in dem die Antenne durch Siebdruck auf den Papierträger gedruckt wird, gedruckt wird.

4. Verfahren nach Anspruch 3, wobei der Teil (18) der dieelektrischen Schicht (12), der dazu bestimmt ist, ein das Ende der Siebdruckantenne (10) mit einer Anschlussfläche des Chips (24) verbindendes Band aufzunehmen, größer als der Rest der dielektrischen Schicht ist.

5. Verfahren nach Anspruch 4, bei dem der Teil (18) der dielektrischen Schicht (12), der dazu bestimmt ist, das leitende Band aufzunehmen, 100 % Dielektrikum enthält, während der Rest der dielektrischen Schicht 30 % Dielektrikum enthält.

6. Verfahren nach Anspruch 5, wobei die Siebdruckschablone, die dazu dient, die dielektrische Schicht (12) zu verwirklichen, eine Abflachung aufweist, die dem Teil (18) entspricht, der dazu bestimmt ist, das leitende Band aufzunehmen, während der Rest der dielektrischen Schicht gerastert ist.
